# EUROPEAN PATENT APPLICATION

(11) **EP 3 667 847 A1**
(43) Date of publication of application: **17.06.2020**
(21) Application number: 19215027.4
(22) Date of filing: 10.12.2019
(51) Int. Cl.: H02G 3/22, H02G 15/013

(54) **ELECTRICAL WIRE SEALING ASSEMBLY**

(30) Priority: 14.12.2018 US 201816220580
(71) Applicant: GE Aviation Systems LLC, Grand Rapids, MI 49512 (US)
(72) Inventor: HATHAWAY, Samuel Robert, Grand Rapids, MI Michigan 49512 (US)
(74) Representative: Openshaw & Co.

(57) **Abstract**

A method and apparatus for an electrical wire sealing assembly (60) can include a body (64) with a first surface (66) and a second surface (68), with a seal passage (70) extending through the body (64) from the first surface (66) to the second surface (68) and including a first tapered portion (76). A seal (80) can be provided within the seal passage (70) having a second tapered portion (98) overlapping the first tapered portion (76) and defining a wire passage (94). A retainer (82) compressively retains the seal (80) in the seal passage (70) to compress the seal (80) about a wire (60) passing through the wire passage (70).

## Description

### TECHNICAL FIELD

The disclosure relates to a method and apparatus for a wire sealing assembly and more specifically to compressively sealing a wire passing through a wire passage.

### BACKGROUND OF THE INVENTION

Contemporary aircraft use avionics in order to control the various equipment and operations for flying the aircraft, among other electrical components. Often electrical components require crimp pin connectors to electrically or communicatively couple separate electrical components. Occasionally, these connectors are subject to fluid leakage at the connector, which can provide contamination of the local electrical components.

One option, in order to fluidly seal such connections, includes a large hermetic seal can be formed around the connector such as with a glue or epoxy, which is large and bulky, and can be difficult to remove. Optionally, a fill can be provided to fill between the wires to seal the wires. However, such a fill is not removable and any inspection or maintenance necessarily requires replacement of the connector.

Additional options include grommets or diaphragms. However, these options often require cutting or splicing the wire, which leads to a greater risk of damage or disconnection. Furthermore, these types of seals may not be able to seal under certain pressures.

### BRIEF DESCRIPTION OF THE INVENTION

In one aspect, the disclosure relates to an electrical wire sealing assembly comprising: a base having opposing first and second surfaces, with a seal passage extending between the first and second surface and the seal passage having a first tapered portion; a seal at least partially located within the seal passage and having a second tapered portion axially overlapping with the first tapered portion and defining a wire passage; a retainer compressively retaining the seal to the base to apply an axial force to the seal to create a reaction compressive force from the first tapered portion to compress the seal about a wire passing through the wire passage.

In another aspect, the present disclosure relates to a wire sealing assembly comprising: a base with an aperture extending through the base with the aperture having a first tapered portion; a seal including a wire passage, located within the aperture, and having a second tapered portion partially, axially overlapping the first tapered portion; and a retainer compressively retaining the seal to the base to apply an axial force to the seal to compress the seal into the aperture of the base.

In yet another aspect, the present disclosure relates to a method of sealing a set of wires with a wire sealing assembly within a seal passage of a component having a first tapered portion, the method comprising: inserting the set of wires through a slit in a seal to a wire passage within the seal; and compressing a second tapered portion of the seal against the first tapered portion of the seal passage to create a reaction compressive force to compress the seal against the set of wires.

### BRIEF DESCRIPTION OF THE DRAWING

In the drawings:
FIG. 1 is a perspective view of an aircraft having an avionics chassis with electrical components in accordance with various aspects described herein.
FIG. 2 is an enlarged, partially exploded perspective view of the avionics chassis of FIG. 1, with a cover removed for clarity and including an electrical wire sealing assembly.
FIG. 3 is an exploded view of the electrical wire sealing assembly of FIG. 2.
FIG. 4 is a sectional view of the partially assembled electrical wire sealing assembly of FIG. 3, with fasteners coupling a retainer to the avionics chassis.
FIG. 5 is a section view of the completed electrical wire sealing assembly of FIG. 4.
FIG. 6 is a section view of an alternative electrical wire sealing assembly for use in the avionics chassis of FIG. 2.

### DETAILED DESCRIPTION OF THE INVENTION

Aspects of the disclosure relate to an improved electrical wire sealing assembly that provides for a fluid seal at the wire as well as provides for easy disassembly, inspection, and reassembly, as well as reduced size and weight. Avionics including electrical components, as well as other engine components, are constantly challenged with dissipating the heat produced within the increasing thermal production within the aircraft environment, which can require the use of local liquids or fluids for heat dissipation, which can require improved sealing within the electrical assemblies. Additionally, sensors or other electrical elements may be provided in contaminable locales, such as those in a fuel tank or an oil conduit, requiring sealing within such locales.

While the description will generally pertain to an avionics chassis within an aircraft, it should be appreciated that the electrical wire sealing assembly can be applicable to a myriad of elements or implementations, such as any electronics chassis, electronics components, motors such as those in an aircraft engine or not in an aircraft, or any other electrical assembly utilizing crimp pin connectors, for example. Therefore, the electrical wire sealing assembly as described herein will also have applicability in other environments where sealed electrical connections are desirable, such as non-aircraft, terrestrial, or other environments, as well as any other electrical environment.

While "a set of' various elements will be described, it will be understood that "a set" can include any number of the respective elements, including only one element. Additionally, all directional references (e.g., radial, axial, upper, lower, upward, downward, left, right, lateral, front, back, top, bottom, above, below, vertical, horizontal, clockwise, counterclockwise) are only used for identification purposes to aid the reader's understanding of the disclosure, and do not create limitations, particularly as to the position, orientation, or use thereof. Connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other. The exemplary drawings are for purposes of illustration only and the dimensions, positions, order and relative sizes reflected in the drawings attached hereto can vary.

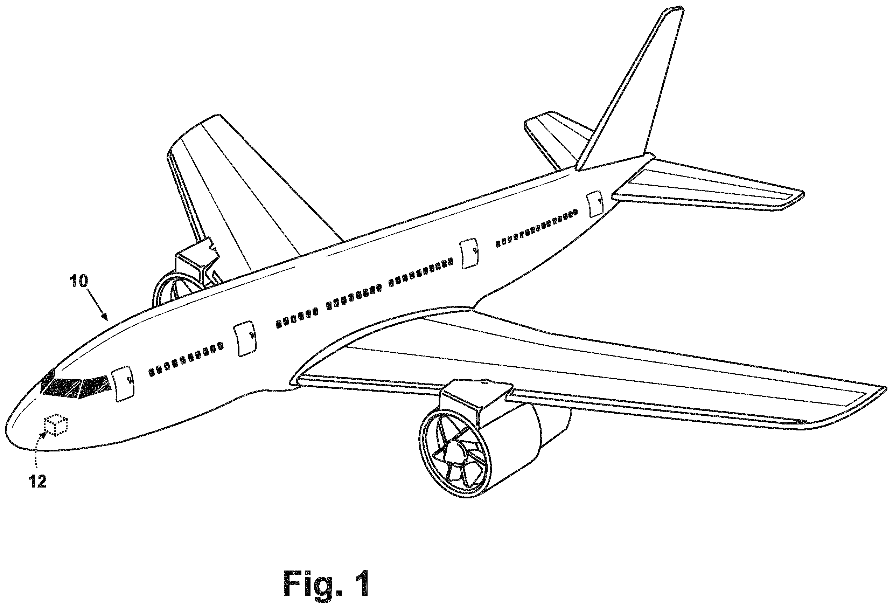

FIG. 1 schematically illustrates an aircraft 10 with an on-board avionics chassis 12 (shown in broken-line) for housing avionics, electronics, electrical components, or avionics components for use in the operation of the aircraft 10. The avionics chassis 12 houses a variety of avionics elements and protects them against contaminants, electromagnetic interference (EMI), radio frequency interference (RFI), vibrations, and the like. While illustrated in a commercial airliner, the avionics chassis 12 can be used in any type of aircraft, for example, without limitation, fixed-wing, rotating-wing, rocket, commercial aircraft, personal aircraft, and military aircraft, as well as any vehicle requiring similar protection. The avionics chassis 12 can be located anywhere within the aircraft, not just the nose as illustrated. Furthermore, aspects of the disclosure are not limited only to aircraft aspects, and can be included in other mobile and stationary configurations. Non-limiting example mobile configurations can include ground-based, water-based, or additional air-based vehicles. Further yet, aspects of the disclosure are not limited to that of an avionics chassis, but any portion of the aircraft electrical connections are made or crimp pin electrical connectors are utilized. Further still, the electrical connections can be those made in an oil-wetted cavity, such as within an on-engine electric motor or generator, where it is desirable to seal the electrical connectors from the wetted cavity.

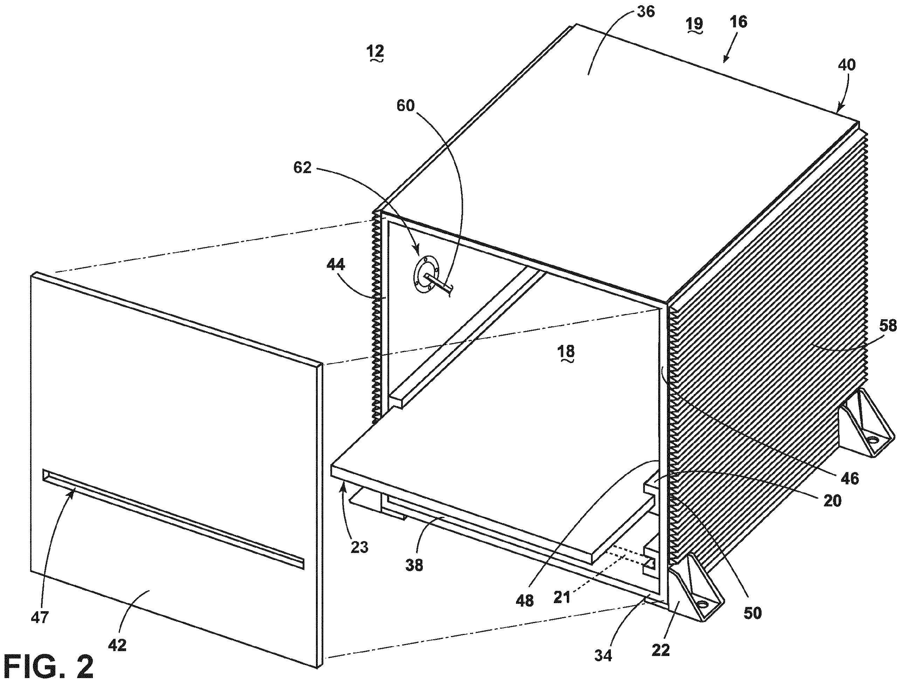

FIG. 2 illustrates the avionics chassis 12 according to an aspect of the present disclosure, with a front cover 42 removed. The avionics chassis 12 includes a chassis housing 16 defining an interior 18 and exterior 19 of the chassis 12. The avionics chassis 12 can includes a chassis frame 34 having a top cover 36, a bottom wall 38, a back wall 40, and opposing sidewalls 44, 46, collectively referred to as the walls. The frame 34 can further include the aforementioned selectively removable front cover 42, providing access to the interior 18 of the avionics chassis 12 when removed, and partially restricting access to the interior 18 when coupled or mounted with the frame 34. The sidewalls 44, 46 can include an interior surface 48 and an exterior surface 50. As shown, a set of heat-dissipating elements, such as fins 58, can project from the exterior surface 50 of the sidewalls 44, 46. While heat-dissipating fins 58 are shown, a number of heat-dissipating elements or heat-dissipating configurations can be utilized by the sidewalls 44, 46 to remove or dissipate at least a portion of heat generated by or within the avionics chassis 12, or heat stored by the avionics chassis 12.

The avionics chassis 12 can further include a set of thermally conductive card rails 20 within the interior 18 and supported by the interior surface 48 of the sidewalls 44, 46. The set of card rails 20 can be horizontally aligned on the interior surfaces 48 of the spaced on opposing sidewalls 44, 46 to define effective card slots 21 (illustrated by the dotted lines) there between for receiving at least a portion of an operable avionics system card 23. While only a single avionics system card 23 is shown, the avionics chassis 12 can be configured to house, support, or include a set of avionics system cards 23.

The removable front cover 42 can be selected or configured to include a set of cover openings 47 that can be aligned with a corresponding set of avionics system cards 23 such that when the front cover 42 is coupled or mounted with the frame 32, at least a portion of the avionics system card 23 can extend from the interior 18 to the exterior 19 of the avionics chassis 12. Stated another way, the avionics chassis 12 or the avionics system card 23 can be selected or configured such that at least a portion of an avionics system card 23 can extend through a corresponding opening 47 or aperture in the chassis 12 or front cover 42. In this sense, the opening 47 can be sized, shaped, profiled, or contoured to align or correspond with at least a portion of the avionics system card 23. While the avionics system card 23 is illustrated extending through an opening 47 in the front cover 42, aspects of the disclosure can be included wherein the avionics system card 23 is selected, designed, or configured such that at least a portion of the card 23 extends beyond or past a physical or referential plane defined by the avionics chassis 12, front cover 42, sidewalls 44, 46, frame 34, or combination of boundaries thereof.

The avionics chassis 12 is further illustrated including a set of mounting feet 22 extending from the chassis housing 16 to facilitate mounting the avionics chassis 12 to the aircraft 10 by means of bolts or other conventional fasteners. Further, the mounting feet 22, can function as an electrical ground for grounding the avionics chassis to the frame of the aircraft 10. While mounting feet 22 are shown in the example the avionics chassis 12 can be used with many types of attachment mechanism.

One or more electrical wires 60 can be provided into or out of the avionics chassis 12. The electrical wires 60 can be sealed with an electrical wire sealing assembly 62 provided on a sidewall 44 of the avionics chassis 12. While shown on the sidewall 44, the electrical wire sealing assembly 62 can be provided anywhere along the avionics chassis 12, or as well as along any other engine component or electrical component. While the discussion herein will be directed to an electrical wire 60, it should be understood that the electrical wire sealing assembly 62 can simply be a sealing assembly, and can seal something other than a wire or electrical wire, such as a tube, conduit, or other element extending through the wall of a component.

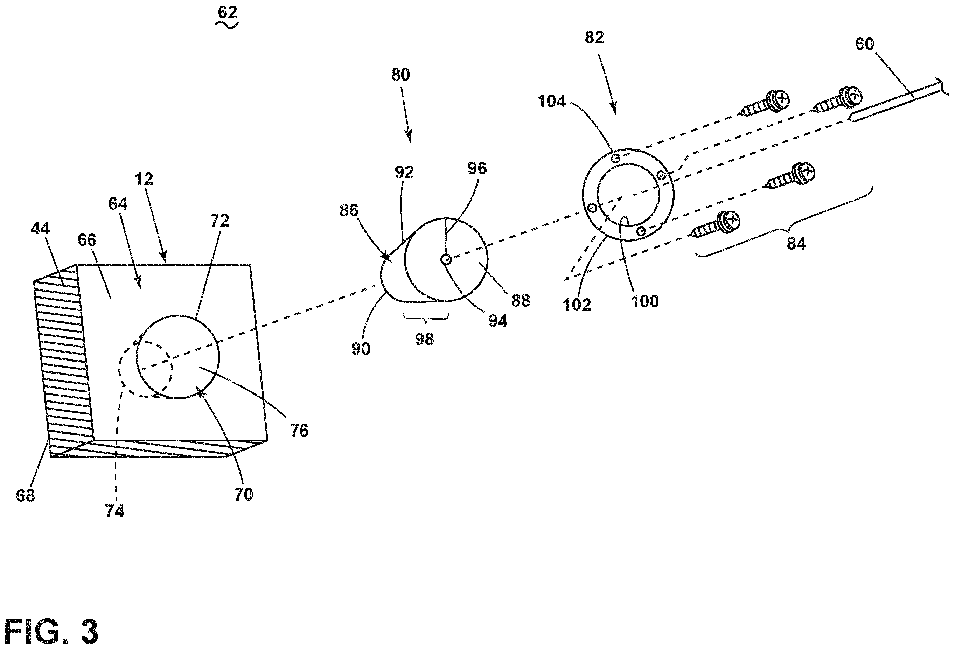

Referring now to FIG. 3, the electrical wire sealing assembly 62 is exploded from a portion of the sidewall 44 of the avionics chassis 12 of FIG. 2, which can define a base 64 for receiving the wire 60 and the electrical wire sealing assembly 62. The base 64 can include an opposite first surface 66 and second surface 68. An aperture defining a seal passage 70 is provided in the sidewall 44 of the avionics chassis 12, having an inlet 72 at the first surface 66 and an outlet 74 at the second surface 68, which can be defined relative to the interior of the avionics chassis 12, for example, while the particular arrangement may be switched. The seal passage 70 includes a decreasing cross-sectional area in a direction from the inlet 72 toward the outlet 74, such that the seal passage 70 converges toward the outlet 74 to define a first tapered portion 76 for the seal passage 70.

The electrical wire sealing assembly 62 includes a seal 80, a retainer 82, and a set of fasteners 84. The seal 80 can include a body 86 having a first end 88 and a second end 90, with a sidewall 92 extending between the first and second ends 88, 90. The first end 88 can include a greater cross-sectional area than the second end 90, such that the seal 80 includes a converging geometry extending at least partially between the first end 88 and the second end 90, to define a second tapered portion 98. The second tapered portion 98 can have a taper that is complementary to that of the first tapered portion 76, for example. A wire passage 94 formed as an aperture through the seal 80 can extend through the body 86, with a slit 96 provided in the body 86 extending from the wire passage 94 to the sidewall 92. The seal 80 can be made of any suitable compressible material, such as rubber or polymers, while a preferred material is one that resists degradation over time. In this way, the seal 80 has a compressible structure, permitting compression about the wire passage 94. While only one slit 96 is shown, any suitable number of slits is contemplated, as well as any number of wire passages 94. Preferably, where a seal 80 is made to accept multiple wires, it will include multiple wire passages 94 each with a dedicated slit 96, while it is contemplated that a single slit or wire aperture can be used with multiple wires.

The retainer 82, shown as an exemplary plate, can be an annular member, for example, having an interior terminal edge 100 and an exterior terminal edge 102, with a set of fastener apertures 104 provided in the retainer 82. While shown as four fastener apertures 104, any suitable number is contemplated for securing the retainer 82 to the base 64. The set of fasteners 84 can be complementary to the set of fastener apertures 104 in the retainer 82. Additionally, alternative shapes for the retainer 82 are contemplated, such that the retainer 82 can be used to fasten to the base 64 to secure the seal 80 within the seal passage 70.

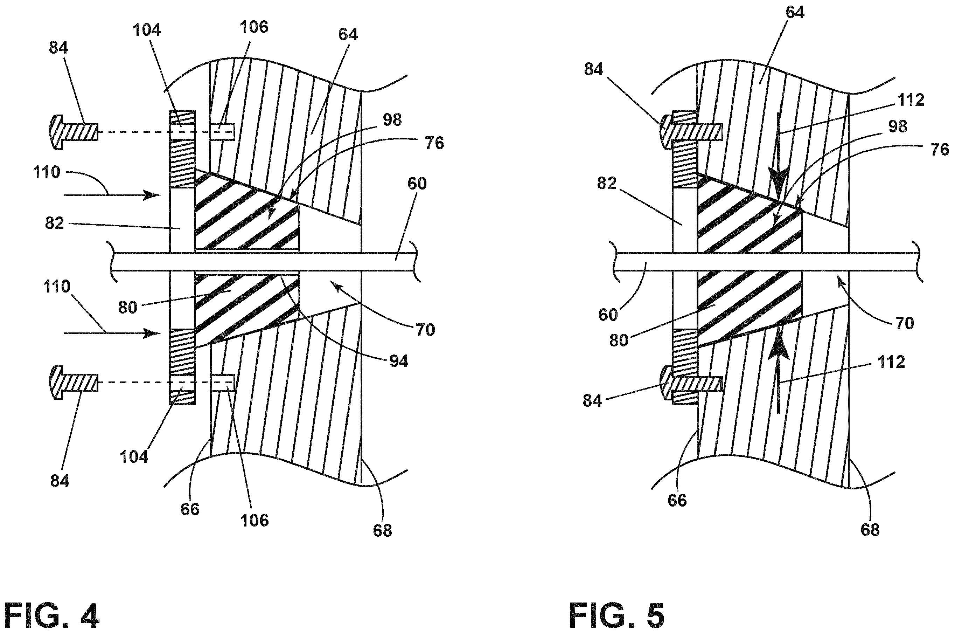

Referring now to FIG. 4, a section view shows the seal 80 partially provided in the seal passage 70 is shown. The wire 60 extends through the wire passage 94, with the seal 80 loosely provided around the wire 60. Alternatively, it is contemplated that the wire passage 94 is sized slightly smaller than the wire 60, providing for compression of the wire 60 inserted through the wire passage 94. The fasteners 84 can insert into the fastener apertures 104 in the retainer 82 to secure the retainer 82 to additional fastener apertures 106 in the base 64. Insertion of the seal 80 into the seal passage 70 provides that the second tapered portion 98 is at least partially received within the first tapered portion 76, while being completely received is contemplated. The fasteners 84 can secure the retainer 82 to the first surface 66 can provide for applying an axial force, represented by arrows 110, compressing the seal 80 within the seal passage 70. While shown as using a fastener to couple the retainer 82 to the base 64, it should be appreciated that other means of attachment are contemplated, such as a threaded connection, a weld, or an adhesive in non-limiting examples.

The seal 80 can be sized slightly larger than the seal passage 70, such that insertion of the seal 80 within the seal passage 70 necessarily requires compression of the seal 80 at the meeting of the first tapered portion 76 of the seal passage 70 and the second tapered portion 98 of the seal 80.

Referring now to FIG. 5, the retainer 82 is shown coupled to the base 64, compressing the seal 80 within the seal passage 70. As the seal 80 is slightly larger than the seal passage 70, the seal is compressed inwardly, as the axial force 110 from the retainer 82 creates a reaction compressive force, represented by arrows 112. The reaction compressive force 112 is in a direction toward the wire passage 94, compressively sealing against the wire 60 passing through the wire passage 94 in the seal 80.

The electrical wire sealing assembly 62 as described herein provides for a simpler seal about an electrical wire or near an electrical connection as opposed to other current methods. The use of the tapered portions provides for converting an axial pressure to a radial or inward compression to seal against a wire extending through the electrical wire assembly 62. Such a seal permits sealing about a wire without requiring splicing of the wires, common to other electrical seals. Furthermore, the electrical wire assembly is smaller and simpler, which provides for less parts, less complexity, reduced cost, as well as less overall weight, which can be critical in an aviation implementation.

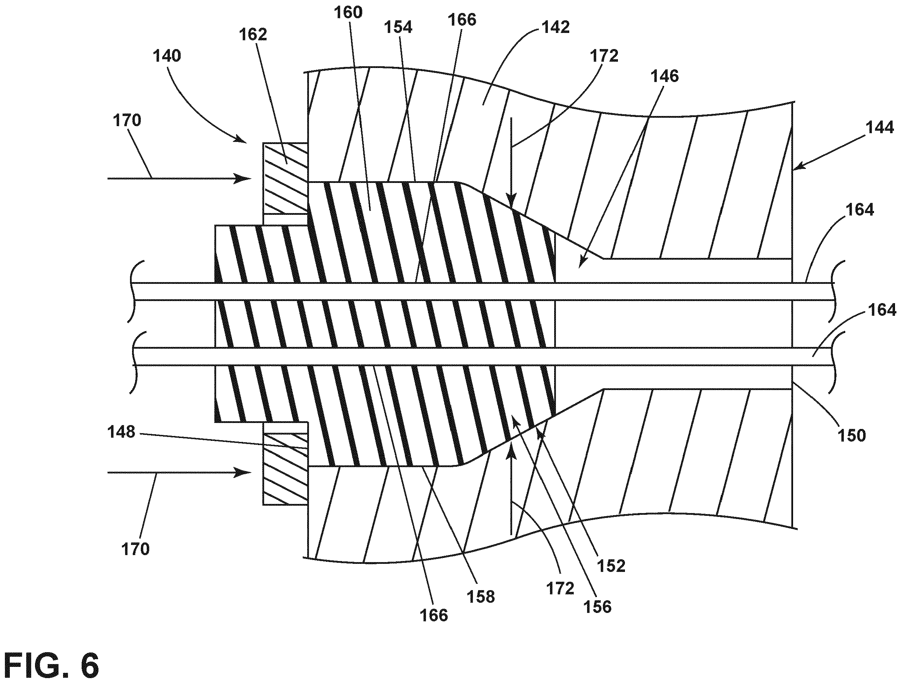

Referring now to FIG. 6, an alternative electrical wire sealing assembly 140 is shown in cross section in an installed position of a base 142 of an electrical component 144, for example, such as within the avionics chassis 12 of FIG. 2. The base 142 can include an aperture as a seal passage 146 having an inlet 148 and an outlet 150. The seal passage 146 can include a first tapered portion 152 having a decreasing cross-sectional area in a direction from the inlet 148 toward the outlet 150 along at least a portion of the seal passage 146. Additionally, the seal passage includes a first straight portion 154, having a constant cross-sectional area between the first tapered portion and the inlet 148.

The electrical wire sealing assembly 140 can include a grommet or seal 160 and a retainer 162. The retainer 162 can be substantially similar to the retainer 82 of FIGS. 3-5, but is shown as welded to the base 142 as opposed to affixed with one or more fasteners. Any alternative manner of fastening the retainer 162 to the base 142 is contemplated, such as welding, fastening, or adhesives in non-limiting examples. The seal 160 can include a slit, similar to the slit 96 of the seal 80 of FIG. 3, but not visible in the cross-sectional view of FIG. 6, permitting insertion of one or more wires 164 into the seal 160 to a wire passage 166. The seal 160 includes a second tapered portion 156 and a second straight portion 158, which can be complementary to the first tapered portion 152 and the first straight portion 154 of the seal passage 146, while the sizing of the seal 160 can be slightly wider or larger than that of the seal passage 146.

Fastening the retainer 162 to the base 142 compresses the seal 160 within the seal passage 146, as illustrated by arrows 170 as an axial force 170. The axial force 170 pushes the seal 160 inwardly with the second tapered portion 156 abutting the first tapered portion 152. Such compression 170 results in an inward compression as a reaction compressive force 172 of the seal 160 at the first tapered portion 152, as illustrated by arrows 172. The inward compression of the seal 160 provides for compression of the seal 160 against the wires 164 to seal the wires 164.

A method of coupling a set of wires 60, 164 with a wire sealing assembly 62, 140 within a seal passage 70, 146 of a component 12 having a first tapered portion 76, 152 can include: inserting the set of wires 60, 164 through a slit 96 in a seal 80,160 to a wire passage 94, 166 within the seal 80, 160; and compressing a second tapered portion 98, 156 of the seal 80, 160 against the first tapered portion 76, 152 of the seal passage 70, 146 to create a reaction compressive force to compress the seal 80, 160 against the wires 60, 164. The method can further include fastening a retainer 82, 162 to the component to compress the seal 80, 160 into the seal passage 70, 146.

The components as described herein can be formed by additive manufacturing, such as 3D printing, direct metal laser melting, direct metal laser sintering, or electroforming, while other manufacturing methods are contemplated.

The electrical wire sealing assembly 60 as described herein provides for a sealing junction within a component that can be sealed to prevent leakage of a gas, liquid, or other substance through wire channels. The electrical wire sealing assembly 60 utilizes a compressed grommet to seal around each wire to prevent the leakage through the wire channel. Furthermore, the electrical wire sealing assembly 60 provides for smaller sizing, which provides for reduced packaging and reduced occupied space, which can be extremely important in tight electronics implementations common to those in avionics applications. Further yet, the smaller sizing provides for less overall weight, which can provide for an improvement in specific fuel consumption in aircraft implementations.

The electrical wire sealing assembly 60 also provides for improved simplicity. Typical, non-hermetic connectors have a small range at which they are able to seal from the elements, and can provide for wire damage or leakage with only a mild pressure gradient provided across the connector. The seal in the present electrical wire sealing assembly 60 provides for a seal across a wide range of pressure gradients and can reduce wire strain. Furthermore, typical electrical connectors require splicing the wires or require a diaphragm, which can be susceptible to increase pressures. The present electrical wire sealing assembly 60 provides for a reliable seal, while being easy to disassemble and reassemble. The present electrical wire sealing assembly 60 provides for easy removal for maintenance and inspection, and can be reused multiple times.

Many other possible configurations in addition to that shown in the above figures are contemplated by the present disclosure. To the extent not already described, the different features and structures of the various aspects can be used in combination with others as desired. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described. Combinations or permutations of features described herein are covered by this disclosure.

This written description uses examples to disclose aspects of the invention, including the best mode, and also to enable any person skilled in the art to practice aspects of the invention, including making and using any devices or systems and performing any incorporated methods. The patentable scope of the invention is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims.

Further aspects of the invention are provided by the subject matter of the following clauses:
1. An electrical wire sealing assembly comprising a base having opposing first and second surfaces, with a seal passage extending between the first and second surface and the seal passage having a first tapered portion, a seal at least partially located within the seal passage and having a second tapered portion axially overlapping with the first tapered portion and defining a wire passage, and a retainer compressively retaining the seal to the base to apply an axial force to the seal to create a reaction compressive force from the first tapered portion to compress the seal about a wire passing through the wire passage.
2. The electrical wire sealing assembly of any preceding clause wherein the seal is made from compressible material.
3. The electrical wire sealing assembly of any preceding clause wherein the seal has a compressible structure.
4. The electrical wire sealing assembly of any preceding clause wherein the base and the retainer have complementary fastener apertures, and at least one fastener can be used to compressively retain the retainer to the base.
5. The electrical wire sealing assembly of any preceding clause wherein the first and second tapered portions have complementary tapers.
6. The electrical wire sealing assembly of any preceding clause wherein the second tapered portion is received within the first tapered portion.
7. The electrical wire sealing assembly of any preceding clause wherein the second tapered portion is completely received within the first tapered portion when the retainer is compressively retained to the base.
8. The electrical wire sealing assembly of any preceding clause wherein the seal passage has a first straight portion in addition to the first tapered portion.
9. The electrical wire sealing assembly of any preceding clause wherein the second tapered portion is sized to be received in the first straight portion.
10. The electrical wire sealing assembly of any preceding clause wherein the seal has a second straight portion, which is sized to be received within the first straight portion.
11. The electrical wire sealing assembly of any preceding clause wherein the seal has multiple wire passages.
12. A sealing assembly comprising a base with an aperture extending through the base with the aperture having a first tapered portion, a seal including a passage, located within the aperture, and having a second tapered portion partially, axially overlapping the first tapered portion, and a retainer compressively retaining the seal to the base to apply an axial force to the seal to compress the seal into the aperture of the base.
13. The sealing assembly of any preceding clause wherein the second tapered portion of the seal is larger than the first tapered portion of the aperture such that the axial force of the retainer results in a compression of the seal toward the passage by the first tapered portion.
14. The sealing assembly of any preceding clause wherein the second tapered portion is at least partially received within the first tapered portion.
15. The sealing assembly of any preceding clause wherein the second tapered portion is completely received within the first tapered portion when the retainer is compressively retained to the base.
16. The sealing assembly of any preceding clause wherein the aperture has a first straight portion in addition to the first tapered portion.
17. The sealing assembly of any preceding clause wherein the seal has a second straight portion, which is sized to be received within the first straight portion.
18. The sealing assembly of any preceding clause wherein the seal has multiple passages.
19. A method of sealing a set of wires with a wire sealing assembly within a seal passage of a component having a first tapered portion, the method comprising inserting the set of wires through a slit in a seal to a wire passage within the seal, and compressing a second tapered portion of the seal against the first tapered portion of the seal passage to create a reaction compressive force to compress the seal against the set of wires.
20. The method of any preceding clause further comprising fastening a retainer to the component to compress the seal into the seal passage.

## Claims

1. An electrical wire sealing assembly (62) comprising:
a base (64) having opposing first and second surfaces (66, 68), with a seal passage (70) extending between the first and second surface (66, 68) and the seal passage (70) having a first tapered portion (76);
a seal (80) at least partially located within the seal passage (70) and having a second tapered portion (98) axially overlapping with the first tapered portion (76) and defining a wire passage (94); and
a retainer (82) compressively retaining the seal (80) to the base (64) to apply an axial force to the seal (80) to create a reaction compressive force from the first tapered portion (76) to compress the seal (80) about a wire (60) passing through the wire passage (94).

2. The electrical wire sealing assembly (62) of claim 1 wherein the seal (80) is made from compressible material.

3. The electrical wire sealing assembly (62) of claim 1 or 2 wherein the seal (80) has a compressible structure.

4. The electrical wire sealing assembly (62) of any of claims 1 to 3 wherein the base (64) and the retainer (82) have complementary fastener apertures (104, 106), and at least one fastener (84) can be used to compressively retain the retainer (82) to the base (64).

5. The electrical wire sealing assembly (62) of any of claims 1 to 4 wherein the first and second tapered portions (76, 98) have complementary tapers.

6. The electrical wire sealing assembly (62) of any of claims 1 to 5 wherein the second tapered portion (98) is received within the first tapered portion (76).

7. The electrical wire sealing assembly (62) of claim 6 wherein the second tapered portion (98) is completely received within the first tapered portion (76) when the retainer (82) is compressively retained to the base (64).

8. The electrical wire sealing assembly (62) of any of claims 1 to 7 wherein the seal passage (70) has a first straight portion (154) in addition to the first tapered portion (76).

9. The electrical wire sealing assembly (62) of claim 8 wherein the second tapered portion (98) is sized to be received in the first straight portion (154).

10. The electrical wire sealing assembly (62) of claim 9 wherein the seal has a second straight portion, which is sized to be received within the first straight portion (154).

11. The electrical wire sealing assembly (62) of any of claims 1 to 10 wherein the seal (80) has multiple wire passages (94).

12. A method of sealing a set of wires with a wire sealing assembly within a seal passage of a component having a first tapered portion, the method comprising:
inserting the set of wires through a slit in a seal to a wire passage within the seal; and
compressing a second tapered portion of the seal against the first tapered portion of the seal passage to create a reaction compressive force to compress the seal against the set of wires.

13. The method of claim 12 further comprising fastening a retainer to the component to compress the seal into the seal passage.
